# FASCICULE DE BREVET EUROPEEN

(11) **EP 3 871 281 B1**
(45) Date de publication et mention de la délivrance du brevet: **28.01.2026**
(21) Numéro de dépôt: 19813090.8
(22) Date de dépôt: 22.10.2019
(51) Int. Cl.: H10K 59/35, H10K 59/122, H10K 59/80, H10K 50/852

(54) **PROCÉDÉ DE FABRICATION D'UN PIXEL D'UN MICRO-ÉCRAN À OLEDS**
VERFAHREN ZUR HERSTELLUNG EINES PIXELS EINER OLED-ANZEIGEVORRICHTUNG
PROCESS OF MANUFACTURING A PIXEL OF AN OLED DISPLAY DEVICE

(30) Priorité: 24.10.2018 FR 1859834
(43) Date de publication de la demande: 01.09.2021
(73) Titulaire: Commissariat à l'Energie Atomique et aux Energies Alternatives, 75015 Paris (FR)
(72) Inventeur: MOLLARD, Laurent, 38054 Grenoble Cedex 09 (FR); MAINDRON, Tony, 38054 Grenoble Cedex 09 (FR); TOURNAIRE, Myriam, 38054 Grenoble Cedex 09 (FR)
(74) Mandataire: INNOV-GROUP
(86) Numéro de dépôt international: PCT/FR2019/052516
(87) Numéro de publication internationale: WO 2020/084250

(56) Documents cités:
- EP-A1- 1 672 962
- US-A1- 2011 127 500
- US-A1- 2014 203 245

## Description

### Domaine technique

L'invention se rapporte au domaine technique des micro-écrans à diodes électroluminescentes organiques (OLEDs).

L'invention trouve notamment son application dans la fabrication de lunettes et casques à réalité virtuelle ou augmentée, de viseurs d'appareil photo, d'afficheurs tête haute, de pico-projecteurs etc.

### Etat de la technique antérieure

Un pixel d'un micro-écran à diodes électroluminescentes organiques à émission vers le haut connu de l'état de la technique, notamment du document EP 1 672 962 A1, comporte successivement :
- un substrat ;
- une première électrode, réfléchissante dans le domaine visible, et formée sur le substrat ;
- une couche d'espacement, formée sur la première électrode ;
- un empilement de couches électroluminescentes organiques, configuré pour émettre une lumière blanche, et formé sur la couche d'espacement,
- une seconde électrode, semi-transparente dans le domaine visible, et formée sur l'empilement ; les première et seconde électrodes formant un résonateur optique.

La couche d'espacement possède des première, deuxième, et troisième portions présentant des épaisseurs adaptées de sorte que le résonateur optique autorise respectivement la transmission de lumières rouge, verte et bleue issues de la lumière blanche émise par l'empilement, de manière à définir respectivement des sous-pixels rouge, vert et bleu.

Un tel pixel de l'état de la technique permet d'envisager de s'affranchir de filtres colorés grâce au résonateur optique de type Fabry-Pérot formant un filtre interférentiel. La gamme de longueurs d'onde filtrées est déterminée par les épaisseurs des première, deuxième et troisième portions de la couche d'espacement permettant d'ajuster l'épaisseur de la cavité optique (délimitée par les première et seconde électrodes) de sorte que le résonateur optique autorise respectivement la transmission de lumières rouge, verte et bleue issue de la lumière blanche émise par l'empilement de couches électroluminescentes organiques.

Ce type de filtrage peut être obtenu de manière analogue pour un micro-écran à émission vers le bas. Pour simplifier la terminologie, on continuera de parler de résonateur, même si les effets d'interférences sont bien moindres en cas d'émission vers le bas.

Toutefois, un tel pixel de l'état de la technique n'est pas entièrement satisfaisant dans la mesure où la commande électronique des sous-pixels rouge, vert et bleu est susceptible de conduire à des phénomènes de diaphonie (« *crosstalk* » en langue anglaise) entre des sous-pixels adjacents dus à la présence d'une conduction électrique latérale entre sous-pixels adjacents par la couche d'espacement et/ou par des couches conductrices au sein de l'empilement de couches électroluminescentes organiques. Le document US2011/127500 décrit un dispositif OLED multicolore présentant des structures résonantes pour chaque sous-pixel de couleur.

### Exposé de l'invention

L'invention vise à remédier en tout ou partie aux inconvénients précités. A cet effet, l'invention a pour objet un procédé de fabrication d'un pixel d'un micro-écran à diodes électroluminescentes organiques tel que décrit dans la revendication 1.

Ainsi, un tel procédé selon l'invention permet d'obtenir un résonateur optique de type Fabry-Pérot tout en réduisant significativement les effets de diaphonie entre les sous-pixels adjacents. Ceci est rendu possible grâce aux faits de :
(i) supprimer la première partie de la couche d'espacement lors de l'étape e),
(ii) enterrer la seconde partie de l'empilement des couches électroluminescentes organiques (i.e. la partie effective située entre les électrodes) à l'intérieur des ouvertures lors de l'étape f).

Un tel procédé selon l'invention permet donc de s'affranchir d'une conduction électrique latérale susceptible d'être occasionnée par la première partie de la couche d'espacement et par la présence de couches conductrices au sein de l'empilement de couches électroluminescentes organiques.

En outre, un tel procédé selon l'invention permet de s'assurer de la présence de la couche d'espacement sur les bords de la première électrode structurée et d'éviter ainsi les effets de bord. Ceci est rendu possible en enterrant la seconde partie de la couche d'espacement à l'intérieur des ouvertures lors de l'étape d).

### Définitions

- Par «micro-écran», on entend un écran dont chaque pixel présente une surface inférieure ou égale à 30 µm par 30 µm.
- Par « substrat », on entend un support physique autoporté, réalisé dans un matériau de base permettant de préférence l'intégration d'un dispositif électronique ou d'un composant électronique. Par exemple, un substrat est classiquement une tranche (« *wafer* » en langue anglaise) découpée dans un lingot monocristallin de matériau semi-conducteur.
- Par « électrode structurée », on entend une électrode présentant une surface discontinue délimitant un ensemble de motifs.
- Par « couche diélectrique », on entend une couche réalisée dans un matériau diélectrique, possédant une conductivité électrique à 300 K inférieure à 10⁻⁸ S.cm⁻¹.
- Par « zones libres », on entend des zones de la première électrode qui ne sont pas recouvertes par la couche diélectrique.
- Par « domaine visible », on entend un spectre électromagnétique compris entre 380 nm et 780 nm.
- Par « transparente », on entend que la couche d'espacement possède un coefficient de transmission en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.
- Par « électriquement conductrice », on entend que la couche d'espacement présente une conductivité électrique à 300 K supérieure ou égale à 10² S/cm.
- Par « à l'intérieur des ouvertures », on entend que la surface de la seconde partie de la couche d'espacement se situe à un niveau inférieur à celui de la surface de la couche diélectrique. De la même façon, on entend que la surface de la seconde partie de l'empilement de couches électroluminescentes organiques se situe à un niveau inférieur à celui de la surface de la couche diélectrique.
- Par « épaisseur », on entend la dimension suivant la normale à la surface du pixel ou du sous-pixel.

Le procédé selon l'invention peut comporter une ou plusieurs des caractéristiques suivantes.

Selon une caractéristique de l'invention, l'étape e) est exécutée de sorte que la seconde partie de la couche d'espacement et la couche diélectrique présentent une hauteur de marche supérieure ou égale à 100 nm à l'issue de l'étape e).

Par « hauteur de marche », on entend la dimension -suivant la normale à la surface du pixel-, séparant la surface de la couche diélectrique de la surface de la seconde partie de la couche d'espacement.

Ainsi, un avantage procuré par une telle hauteur de marche est de pouvoir réduire significativement les effets de diaphonie entre les sous-pixels rouges, verts et bleus. En effet, la conduction électrique latérale, susceptible d'être occasionnée par la présence de couches conductrices au sein de l'empilement de couches électroluminescentes organiques, est fortement limitée grâce à cette hauteur de marche.

Selon une caractéristique de l'invention, l'étape e) est exécutée par un polissage mécano-chimique.

Ainsi, un avantage procuré est la rapidité de l'opération consistant à supprimer la première partie de la couche d'espacement.

Selon une caractéristique de l'invention, la couche d'espacement formée lors de l'étape d) comporte au moins un oxyde, électriquement conducteur et transparent dans le domaine visible.

Selon une caractéristique de l'invention, le ou les oxydes sont sélectionnés parmi l'oxyde d'indium-étain, l'oxyde d'étain SnO₂, l'oxyde de zinc ZnO.

Selon une caractéristique de l'invention, l'étape d) est exécutée de sorte que la première épaisseur est 100 nm, la deuxième épaisseur est 50 nm, et la troisième épaisseur est 10 nm.

Selon une caractéristique de l'invention, les ouvertures formées lors de l'étape c) présentent une largeur comprise entre 500 nm et 10 µm.

Selon une caractéristique de l'invention, la couche diélectrique formée lors de l'étape b) est réalisée dans un matériau choisi parmi SiO₂ et SiN.

Selon une caractéristique de l'invention, la couche diélectrique formée lors de l'étape b) présente une épaisseur comprise entre 150 nm et 300 nm.

Ainsi, un avantage procuré est de combiner à la fois :
- une épaisseur suffisamment importante pour obtenir une hauteur de marche satisfaisante (typiquement supérieure ou égale à 100 nm) entre la seconde partie de la couche d'espacement et la couche diélectrique après la consommation de matière due au polissage mécano-chimique exécuté lors de l'étape b) ;
- une épaisseur suffisamment faible pour ne pas augmenter indûment la durée de formation de la couche diélectrique.

Selon une caractéristique de l'invention, les première et seconde électrodes sont réalisées dans un matériau métallique, de préférence sélectionné parmi Al, Ag, Pt, Cr, Ni, W, et/ou réalisées dans un oxyde transparent conducteur.

De tels matériaux métalliques possèdent à la fois un coefficient de réflexion en intensité élevée dans le domaine visible, et une conductivité électrique élevée. On privilégiera un oxyde, électriquement conducteur et transparent dans le domaine visible, lorsque l'électrode doit être transparente ou semi-transparente.

Selon une caractéristique de l'invention, le substrat prévu lors de l'étape a) est transparent dans le domaine visible, la première électrode structurée prévue lors de l'étape a) est semi-transparente dans le domaine visible, la seconde électrode formée lors de l'étape g) est réfléchissante dans le domaine visible.

Par « transparent », on entend que le substrat possède un coefficient de transmission en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

Par « semi-transparente », on entend que la première électrode structurée possède un coefficient de transmission en intensité compris entre 30% et 70% moyenné sur le domaine visible.

Par « réfléchissante », on entend que la seconde électrode possède un coefficient de réflexion en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

Ainsi, un avantage procuré est d'obtenir une structure dite à émission vers le bas, c'est-à-dire à travers le substrat.

Selon une caractéristique de l'invention, le substrat prévu lors de l'étape a) est réalisé dans un matériau semi-conducteur, de préférence le silicium, ou réalisé en verre, la première électrode structurée prévue lors de l'étape a) est réfléchissante dans le domaine visible, la seconde électrode formée lors de l'étape g) est semi-transparente dans le domaine visible.

Par « semi-conducteur », on entend que le matériau présente une conductivité électrique à 300 K comprise entre 10⁻⁸ S.cm⁻¹ et 10² S.cm⁻¹.

Par « réfléchissante », on entend que la première électrode structurée possède un coefficient de réflexion en intensité supérieur ou égal à 70%, de préférence supérieur ou égal à 80%, plus préférentiellement supérieur ou égal à 85%, encore plus préférentiellement supérieur ou égal à 90%, moyenné sur le domaine visible.

Par « semi-transparente », on entend que la seconde électrode possède un coefficient de transmission en intensité compris entre 30% et 70% moyenné sur le domaine visible.

Ainsi, un avantage procuré est d'obtenir une structure dite à émission vers le haut, c'est-à-dire à travers la seconde électrode. Le substrat peut alors comporter un circuit de commande des sous-pixels rouges, verts, et bleus sans nuire à l'efficacité lumineuse du micro-écran. On choisira un circuit de type TFT (Transistors en couches minces « *Thin Film Transistors* » en langue anglaise) lorsque le substrat est réalisé en verre, et un circuit de type CMOS (« *Complementary Metal Oxide Semiconductor* » en langue anglaise) lorsque le substrat est réalisé dans un matériau semi-conducteur, en particulier Si.

### Brève description des dessins

D'autres caractéristiques et avantages apparaîtront dans l'exposé détaillé de différents modes de réalisation de l'invention, l'exposé étant assorti d'exemples et de références aux dessins joints.

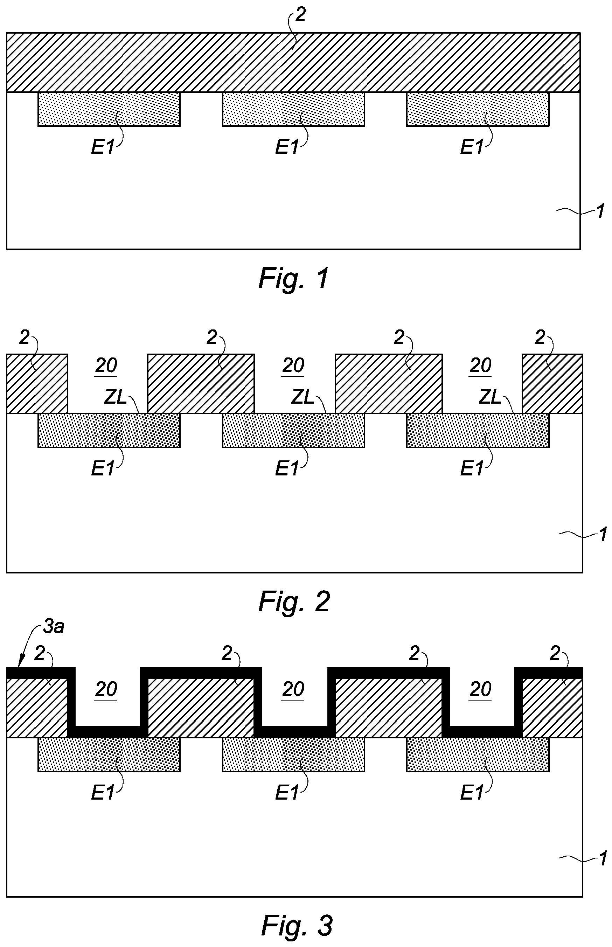

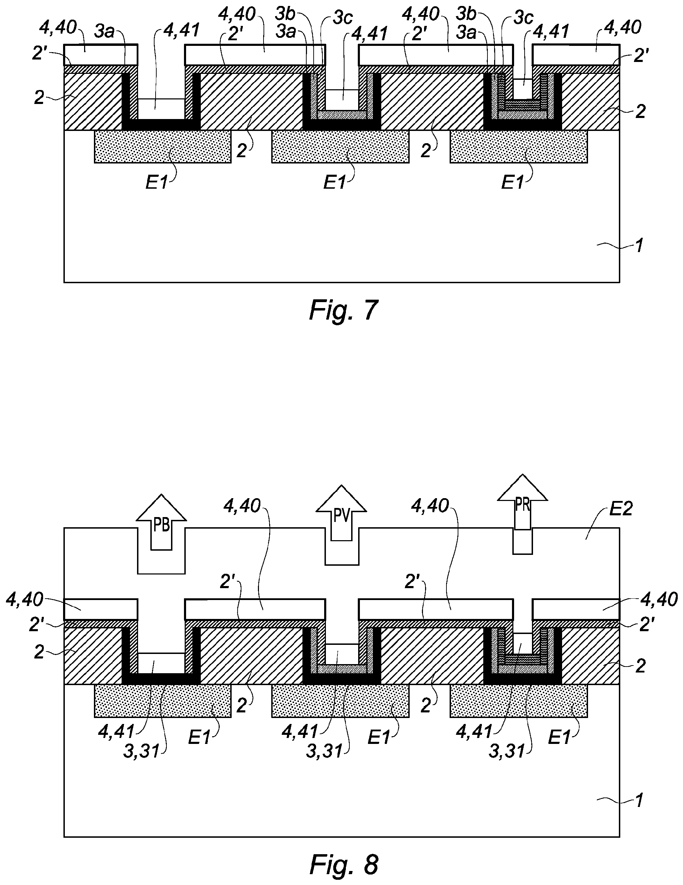

Figures 1 à 8 sont des vues schématiques en coupe selon la normale au substrat, illustrant des étapes d'un procédé selon l'invention.

Il est à noter que les dessins décrits ci-avant sont schématiques et ne sont pas à l'échelle par souci de lisibilité et pour simplifier leur compréhension.

### Exposé détaillé des modes de réalisation

Les éléments identiques ou assurant la même fonction porteront les mêmes références pour les différents modes de réalisation, par souci de simplification.

Comme illustré aux figures 1 à 8, un objet de l'invention est un procédé de fabrication d'un pixel d'un micro-écran à diodes électroluminescentes organiques, comportant les étapes successives :
a) prévoir un substrat 1 comportant une première électrode E1 structurée ;
b) former une couche diélectrique 2 sur la première électrode E1 structurée ;
c) former des ouvertures 20 dans la couche diélectrique 2 de sorte que la première électrode E1 structurée présente des zones libres ZL, les ouvertures 20 étant destinées à accueillir des sous-pixels rouge, vert et bleu PR, PV, PB ;
d) former une couche d'espacement 3, transparente dans le domaine visible et électriquement conductrice, et comportant :
   - une première partie 30 s'étendant sur la couche diélectrique 2, et
   - une seconde partie 31 s'étendant sur les zones libres ZL de la première électrode E1 structurée, à l'intérieur des ouvertures 20 ;
e) supprimer la première partie 30 de la couche d'espacement 3 ;
f) former un empilement 4 de couches électroluminescentes organiques, configuré pour émettre une lumière blanche, et comportant :
   - une première partie 40 s'étendant sur la couche diélectrique 2, et
   - une seconde partie 41 s'étendant sur la seconde partie 31 de la couche d'espacement 3, à l'intérieur des ouvertures 20 ;
g) former une seconde électrode E2 sur l'empilement 4 de couches électroluminescentes organiques de manière à obtenir un résonateur optique avec la première électrode E1 ;
l'étape d) étant exécutée de sorte que la seconde partie 31 de la couche d'espacement 3 présente des première, deuxième et troisième épaisseurs dans les ouvertures 20 adaptées de sorte que le résonateur optique autorise respectivement la transmission de lumières rouge, verte et bleue issues de la lumière blanche émise par l'empilement 4 de couches électroluminescentes organiques.

Les étapes a) et b) sont illustrées à la figure 1. L'étape c) est illustrée à la figure 2. L'étape d) est illustrée aux figures 3 à 5. L'étape e) est illustrée à la figure 6. L'étape f) est illustrée à la figure 7. L'étape g) est illustrée à la figure 8.

### Substrat et types d'architectures

Selon une première architecture dite à émission vers le bas :
- le substrat 1 prévu lors de l'étape a) est transparent dans le domaine visible, et peut être réalisé en verre,
- la première électrode E1 structurée prévue lors de l'étape a) est semi-transparente dans le domaine visible, et peut être réalisée par exemple dans un oxyde transparent conducteur,
- la seconde électrode E2 formée lors de l'étape g) est réfléchissante dans le domaine visible, et peut être réalisée par exemple dans un matériau métallique.

Selon une seconde architecture dite à émission vers le haut :
- le substrat 1 prévu lors de l'étape a) est réalisé dans un matériau semi-conducteur, de préférence le silicium, ou réalisé en verre,
- la première électrode E1 structurée prévue lors de l'étape a) est réfléchissante dans le domaine visible, et peut être par exemple réalisée dans un matériau métallique,
- la seconde électrode E2 formée lors de l'étape g) est semi-transparente dans le domaine visible, et peut être par exemple réalisée dans un oxyde transparent conducteur.

### Première électrode structurée

La première électrode E1 structurée est avantageusement réalisée dans un matériau métallique, de préférence sélectionné parmi Al, Ag, Pt, Cr, Ni, W, ou réalisée dans un oxyde transparent conducteur.

La première électrode E1 est préférentiellement une anode. Toutefois, la première électrode E1 peut être une cathode si la structure de l'empilement 4 de couches électroluminescentes organiques est inversée.

L'étape a) peut comporter les étapes :
a₁) prévoir le substrat 1 ;
a₂) déposer la première électrode E1 sur le substrat 1 par un dépôt de type pleine plaque, selon une technique de dépôt connue de l'homme du métier ;
a₃) structurer la première électrode E1 par une lithogravure.

Les motifs de la première électrode E1 structurée sont préférentiellement séparés d'une largeur comprise entre 0,5 µm et 1 µm. Cette largeur permet d'obtenir un pas d'une matrice de sous-pixels d'un micro-écran préférentiellement compris entre 4 µm et 5 µm.

Lorsque l'architecture est à émission vers le bas, la première électrode E1 structurée présente une épaisseur adaptée pour être semi-transparente dans le domaine visible. La première électrode E1 peut alors être réalisée par exemple dans un oxyde transparent conducteur (e.g. ITO).

Lorsque l'architecture est à émission vers le haut, la première électrode E1 structurée présente une épaisseur adaptée pour être réfléchissante dans le domaine visible. La première électrode E1 peut alors être réalisée par exemple dans un matériau métallique.

### Couche diélectrique

La couche diélectrique 2 formée lors de l'étape b) est avantageusement réalisée dans un matériau choisi parmi SiO₂ et SiN.

L'étape b) peut être exécutée par une technique de dépôt connue de l'homme du métier.

La couche diélectrique 2 formée lors de l'étape b) présente avantageusement une épaisseur comprise entre 150 nm et 300 nm.

L'étape c) peut être exécutée par une technique de gravure connue de l'homme du métier de manière à obtenir des flancs de gravure suffisamment raides pour que la seconde partie 31 de la couche d'espacement 3 et la couche diélectrique 2 présentent une hauteur de marche supérieure ou égale à 100 nm à l'issue de l'étape e), afin d'assurer la discontinuité du dépôt de l'empilement 4 de couches électroluminescentes organiques. Les ouvertures 20 formées lors de l'étape c) présentent avantageusement une largeur comprise entre 500 nm et 10 µm. Les ouvertures 20 de la couche diélectrique 2 peuvent présenter une section transversale rectangulaire. Par « section transversale », on entend une section effectuée suivant la normale à la surface du pixel, c'est-à-dire dans l'épaisseur de la couche diélectrique 2. A titre de variante, les ouvertures 20 de la couche diélectrique 2 peuvent présenter une section transversale de forme différente, qui serait favorable à l'extraction de lumière, par exemple une section transversale parabolique.

### Formation de la couche d'espacement

La couche d'espacement 3 formée lors de l'étape d) comporte avantageusement au moins un oxyde, électriquement conducteur et transparent dans le domaine visible (dénommé ci-après TCO pour « *Transparent Conductive Oxide* »)*.* Le ou les oxydes sont avantageusement sélectionnés parmi l'oxyde d'indium-étain, l'oxyde d'étain SnO₂, l'oxyde de zinc ZnO. L'oxyde de zinc ZnO est préférentiellement dopé à l'aluminium. L'oxyde d'étain SnO₂ est préférentiellement dopé à l'aluminium. Il est également possible d'envisager d'autres dérivés de l'oxyde d'indium-étain, de l'oxyde d'étain SnO₂, et de l'oxyde de zinc ZnO.

L'étape d) est exécutée de sorte que la seconde partie 31 de la couche d'espacement 3 présente les première, deuxième et troisième épaisseurs dans les ouvertures 20 destinées à accueillir respectivement les sous-pixels rouges, verts et bleus PR, PV, PB. A cet effet, l'étape d) peut comporter les étapes successives :
d₁) déposer un premier TCO 3a sur la couche diélectrique 2 et dans les ouvertures 20 de la couche diélectrique 2 ;
d₂) masquer les ouvertures 20 destinées à accueillir les sous-pixels bleus PB ;
d₃) déposer un deuxième TCO 3b sur le premier TCO ;
d₄) masquer les ouvertures 20 destinées à accueillir les sous-pixels verts PV ;
d₅) déposer un troisième TCO 3c sur le deuxième TCO.

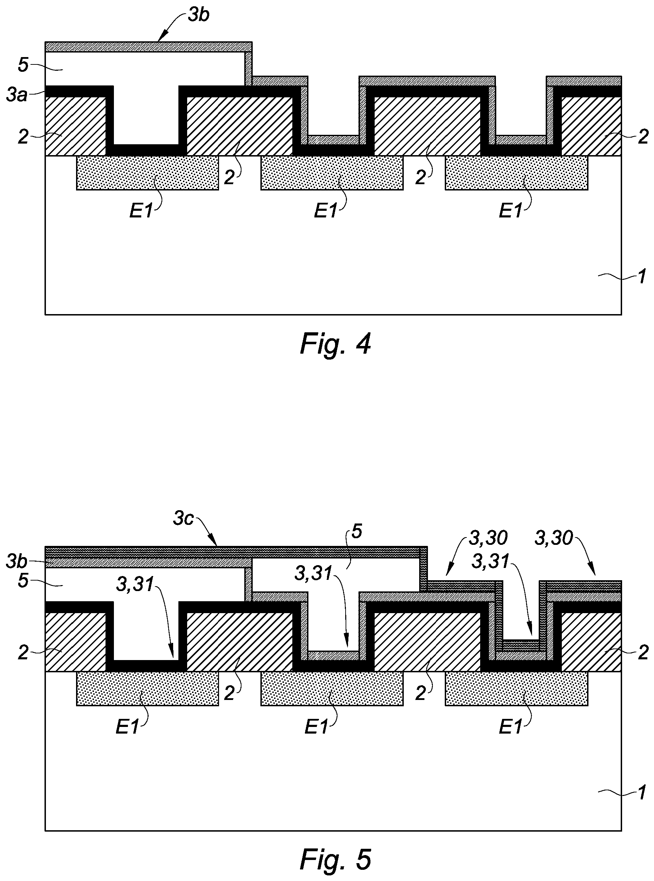

L'étape d₁) est illustrée à la figure 3. Les étapes d₂) et d₃) sont illustrées à la figure 4. Les étapes d₄) et d₅) sont illustrées à la figure 5.

Les étapes d₁), d₃), et d₅) sont exécutées par des techniques de dépôt connues de l'homme du métier. Les étapes d₂) et d₄) peuvent être exécutées à l'aide d'une résine 5 photosensible. La première épaisseur de la seconde partie 31 de la couche d'espacement 3 correspond à l'épaisseur du premier TCO 3a déposé lors de l'étape d₁). La deuxième épaisseur de la seconde partie 31 de la couche d'espacement 3 correspond à la somme des épaisseurs des premier et deuxième TCO 3a, 3b déposés respectivement lors des étapes d₁) et d₃). La troisième épaisseur de la seconde partie 31 de la couche d'espacement 3 correspond à la somme des épaisseurs des premier, deuxième et troisième TCO 3a, 3b, 3c déposés respectivement lors des étapes d₁), d₃) et d₅). Il est à noter que les premier, deuxième et troisième TCO 3a, 3b, 3c peuvent être réalisés dans des matériaux identiques ou différents.

L'étape d) est avantageusement exécutée de sorte que la première épaisseur est 100 nm, la deuxième épaisseur est 50 nm, et la troisième épaisseur est 10 nm. Les valeurs de ces épaisseurs s'entendent dans les tolérances usuelles liées aux conditions expérimentales de dépôt, et non comme des valeurs parfaitement égales au sens mathématique du terme.

### Suppression de la couche d'espacement

L'étape e) est avantageusement exécutée de sorte que la seconde partie 31 de la couche d'espacement 3 et la couche diélectrique 2 présentent une hauteur de marche supérieure ou égale à 100 nm à l'issue de l'étape e).

L'étape e) est avantageusement exécutée par un polissage mécano-chimique. L'étape e) est exécutée de manière à rendre libre la surface de la couche diélectrique 2. Par ailleurs, une telle étape e) permet l'aplanissement de la surface de la couche diélectrique 2.

L'étape e) peut s'accompagner d'une suppression d'une partie de la couche diélectrique 2 sous-jacente lorsque la première partie 30 de la couche d'espacement 3 présente une épaisseur trop fine.

Les résines 5 photosensibles utilisées lors des étapes d₂) et d₄) restant dans les ouvertures 20 sont ensuite retirées après l'étape e) par des techniques de « *stripping* » connues de l'homme du métier.

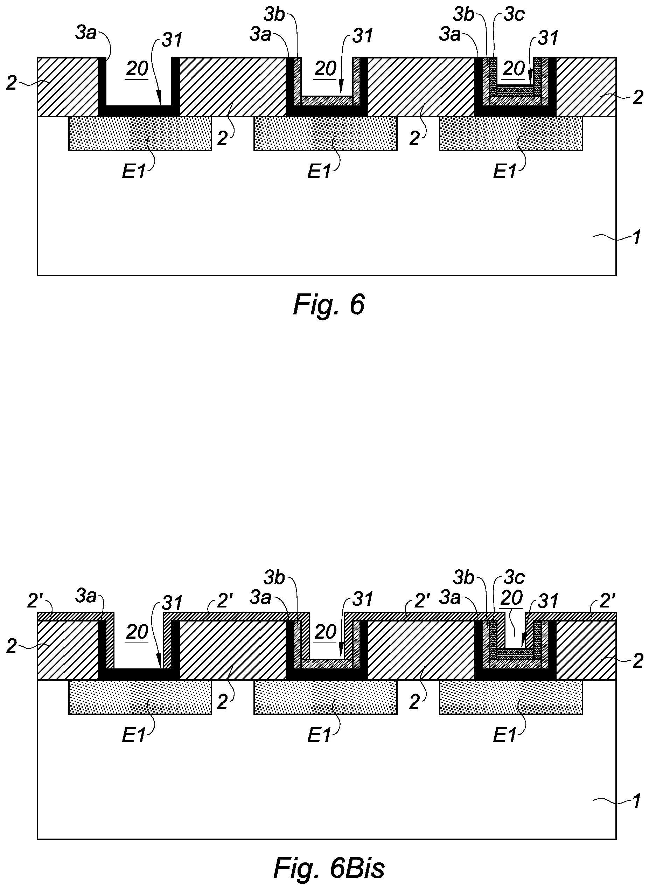

Comme illustré à la figure 6bis, un film diélectrique 2' est ensuite avantageusement formé sur la surface libre de la couche diélectrique 2 et sur la seconde partie 31 de la couche d'espacement 3. A titre d'exemples non limitatifs, le film diélectrique 2' peut être réalisé dans un matériau choisi parmi Al₂O₃, HfO₂, Ta₂O₅. Le film diélectrique 2' présente avantageusement une épaisseur comprise entre 1 nm et 10 nm, de préférence comprise entre 1 nm et 5 nm. Le film diélectrique 2' peut être formé par un dépôt de couches atomiques (ALD « *Atomic Layer Deposition* » en langue anglaise). Le film diélectrique 2' est ensuite gravé dans les ouvertures 20, en fond de tranchée, de manière à libérer la seconde partie 31 de la couche d'espacement 3. Le film diélectrique 2' est gravé au fond des ouvertures 20 de manière à ne pas réduire indûment les dimensions des sous-pixels rouge, vert et bleu PR, PV, PB, tout en assurant une fonction d'isolation électrique. La gravure du film diélectrique 2' dans le fond des ouvertures 20 peut être exécutée par lithographie. Le film diélectrique 2' obtenu est agencé de manière à éviter un court-circuit entre les première et seconde électrodes E1, E2. Le cas échéant, l'étape f) est exécutée de sorte que la première partie 40 de l'empilement 4 de couches électroluminescentes organiques s'étend sur le film diélectrique 2'.

### Empilement de couches électroluminescentes organiques

L'empilement 4 de couches électroluminescentes organiques formé lors de l'étape f) présente une épaisseur constante pour chaque sous-pixel rouge, vert et bleu PR, PV, PB.

A titre d'exemple non limitatif, l'empilement 4 peut comporter trois couches émissives en architecture tandem. Plus précisément, lorsque la première électrode E1 structurée est une anode et la seconde électrode E2 est une cathode, l'empilement 4 peut comporter :
- une première couche de transport de trous formée sur la première électrode E1 structurée ;
- une première couche émissive émettant une lumière bleue, formée sur la première couche de transport de trous ;
- une première couche de transport d'électrons, formée sur la première couche émissive ;
- une couche de génération de charges (appelée également couche d'interconnexion), formée sur la première couche de transport d'électrons ;
- une seconde couche de transport de trous, formée sur la couche de génération de charges ;
- une deuxième couche émissive émettant une lumière verte, formée sur la seconde couche de transport de trous ;
- une troisième couche émissive émettant une lumière rouge, formée sur la deuxième couche émissive ;
- une seconde couche de transport d'électrons, formée sur la troisième couche émissive, et destinée à être revêtue de la seconde électrode E2.

A titre de variantes, l'empilement 4 peut comporter :
- trois couches émissives émettant respectivement des lumières bleue, verte et rouge sans être agencées en architecture tandem (structure conventionnelle) ;
- deux couches émissives émettant respectivement des lumières jaune et bleue agencées en structure conventionnelle ;
- deux couches émissives émettant respectivement des lumières jaune et bleue agencées en structure tandem.

L'étape f) est exécutée par des techniques de dépôt connues de l'homme du métier.

### Seconde électrode

La seconde électrode E2 est avantageusement réalisée dans un matériau métallique, de préférence sélectionné parmi Al, Ag, Pt, Cr, Ni, W, ou réalisée dans un oxyde transparent conducteur.

La seconde électrode E2 est préférentiellement une cathode. Toutefois, la seconde électrode E2 peut être une anode si la structure de l'empilement 4 de couches électroluminescentes organiques est inversée.

L'étape g) est exécutée par une technique de dépôt connue de l'homme du métier. L'étape g) est préférentiellement exécutée par un dépôt suffisamment conforme de manière à assurer le passage de la marche entre les première et seconde parties 40, 41 de l'empilement 4 de couches électroluminescentes organiques.

La seconde électrode E2 est avantageusement revêtue d'une couche d'encapsulation (non illustrée) adaptée pour protéger de l'air et de l'humidité la seconde électrode E2 et l'empilement 4 de couches électroluminescentes organiques.

Lorsque l'architecture est à émission vers le bas, la seconde électrode E2 présente une épaisseur adaptée pour être réfléchissante dans le domaine visible. La seconde électrode E2 peut alors être réalisée par exemple dans un matériau métallique.

Lorsque l'architecture est à émission vers le haut, la seconde électrode E2 présente une épaisseur adaptée pour être semi-transparente dans le domaine visible. La seconde électrode E2 peut alors être réalisée par exemple dans un oxyde transparent conducteur (e.g. ITO).

L'invention ne se limite pas aux modes de réalisation exposés. L'homme du métier est mis à même de considérer leurs combinaisons techniquement opérantes dans la limite de l'étendue de l'invention telle que définie par les revendications annexées.

## Revendications

1. Procédé de fabrication d'un pixel d'un micro-écran à diodes électroluminescentes organiques, comportant les étapes successives :
a) prévoir un substrat (1) comportant une première électrode (E1) structurée ;
b) former une couche diélectrique (2) sur la première électrode (E1) structurée ;
c) former des ouvertures (20) dans la couche diélectrique (2) de sorte que la première électrode (E1) structurée présente des zones libres (ZL), les ouvertures (20) étant destinées à accueillir des sous-pixels rouge, vert et bleu (PR, PV, PB), la couche diélectrique (2) présentant une surface inférieure, une surface supérieure et des flancs reliant la surface inférieure à la surface supérieure
d) former une couche d'espacement (3), transparente dans le domaine visible et électriquement conductrice, et comportant :
- une première partie (30) s'étendant sur la surface supérieure de la couche diélectrique (2), et
- une seconde partie (31) s'étendant sur les zones libres (ZL) de la première électrode (E1) structurée, à l'intérieur des ouvertures (20) de sorte que la surface supérieure de la seconde partie (31) de la couche d'espacement (3) se situe à un niveau inférieur à celui de la surface supérieure de la couche diélectrique (2) ;
e) supprimer la première partie (30) de la couche d'espacement (3) ;
f) former un empilement (4) de couches électroluminescentes organiques, configuré pour émettre une lumière blanche, et comportant :
- une première partie (40) s'étendant sur la surface supérieure de la couche diélectrique (2), et
- une seconde partie (41) s'étendant sur la seconde partie (31) de la couche d'espacement (3), à l'intérieur des ouvertures (20) de sorte que la surface supérieure de la seconde partie (41) de l'empilement (4) se situe à un niveau inférieur à celui de la surface supérieure de la couche diélectrique (2), l'empilement de couches électroluminescentes organiques présentant une discontinuité entre la première partie de l'empilement et la deuxième partie de l'empilement ;
g) former une seconde électrode (E2) sur l'empilement (4) de couches électroluminescentes organiques de manière à obtenir un résonateur optique avec la première électrode (E1) ;
l'étape d) étant exécutée de sorte que la seconde partie (31) de la couche d'espacement (3) présente des première, deuxième et troisième épaisseurs dans les ouvertures (20) adaptées de sorte que le résonateur optique autorise respectivement la transmission de lumières rouge, verte et bleue issues de la lumière blanche émise par l'empilement (4) de couches électroluminescentes organiques.

2. Procédé selon la revendication 1, dans lequel l'étape e) est exécutée de sorte que la seconde partie (31) de la couche d'espacement (3) et la couche diélectrique (2) présentent une hauteur de marche supérieure ou égale à 100 nm à l'issue de l'étape e).

3. Procédé selon la revendication 1 ou 2, dans lequel l'étape e) est exécutée par un polissage mécano-chimique.

4. Procédé selon l'une des revendications 1 à 3, dans lequel la couche d'espacement (3) formée lors de l'étape d) comporte au moins un oxyde, électriquement conducteur et transparent dans le domaine visible.

5. Procédé selon la revendication 4, dans lequel le ou les oxydes sont sélectionnés parmi l'oxyde d'indium-étain, l'oxyde d'étain SnO₂, l'oxyde de zinc ZnO.

6. Procédé selon l'une des revendications 1 à 5, dans lequel l'étape d) est exécutée de sorte que la première épaisseur est 100 nm, la deuxième épaisseur est 50 nm, et la troisième épaisseur est 10 nm.

7. Procédé selon l'une des revendications 1 à 6, dans lequel les ouvertures (20) formées lors de l'étape c) présentent une largeur comprise entre 500 nm et 10 µm.

8. Procédé selon l'une des revendications 1 à 7, dans lequel la couche diélectrique (2) formée lors de l'étape b) est réalisée dans un matériau choisi parmi SiO₂ et SiN.

9. Procédé selon l'une des revendications 1 à 8, dans lequel la couche diélectrique (2) formée lors de l'étape b) présente une épaisseur comprise entre 150 nm et 300 nm.

10. Procédé selon l'une des revendications 1 à 9, dans lequel les première et seconde électrodes (E1, E2) sont réalisées dans un matériau métallique, de préférence sélectionné parmi Al, Ag, Pt, Cr, Ni, W, et/ou réalisées dans un oxyde transparent conducteur.

11. Procédé selon l'une des revendications 1 à 10, dans lequel :
- le substrat (1) prévu lors de l'étape a) est transparent dans le domaine visible,
- la première électrode (E1) structurée prévue lors de l'étape a) est semi-transparente dans le domaine visible,
- la seconde électrode (E2) formée lors de l'étape g) est réfléchissante dans le domaine visible.

12. Procédé selon l'une des revendications 1 à 10, dans lequel :
- le substrat (1) prévu lors de l'étape a) est réalisé dans un matériau semi-conducteur, de préférence le silicium, ou réalisé en verre,
- la première électrode (E1) structurée prévue lors de l'étape a) est réfléchissante dans le domaine visible,
- la seconde électrode (E2) formée lors de l'étape g) est semi-transparente dans le domaine visible.

## Patentansprüche

1. Verfahren zur Herstellung eines Pixels eines Mikrodisplays mit organischen Leuchtdioden, umfassend die folgenden Schritte:
a) Bereitstellen eines Substrats (1), das eine strukturierte erste Elektrode (E1) umfasst;
b) Bilden einer dielektrischen Schicht (2) auf der strukturierten ersten Elektrode (E1);
c) Bilden von Öffnungen (20) in der dielektrischen Schicht (2), so dass die strukturierte erste Elektrode (E1) freie Zonen (ZL) aufweist, wobei die Öffnungen (20) dazu bestimmt sind, rote, grüne und blaue Subpixel (PR, PV, PB) aufzunehmen, wobei die dielektrische Schicht (2) eine untere Fläche, eine obere Fläche und Flanken, die die untere Fläche mit der oberen Fläche verbinden, aufweist;
d) Bilden einer Abstandsschicht (3), die im sichtbaren Bereich transparent und elektrisch leitfähig ist und umfasst:
- einen ersten Teil (30), der sich auf der oberen Fläche der dielektrischen Schicht (2) erstreckt, und
- einen zweiten Teil (31), der sich auf den freien Zonen (ZL) der strukturierten ersten Elektrode (E1), im Inneren der Öffnungen (20), erstreckt, so dass die obere Fläche des zweiten Teils (31) der Abstandsschicht (3) auf einer geringeren Höhe als die obere Fläche der dielektrischen Schicht (2) gelegen ist;
e) Entfernen des ersten Teils (30) der Abstandsschicht (3);
f) Bilden eines Stapels (4) aus organischen lichtemittierenden Schichten, der dazu ausgelegt ist, ein weißes Licht zu emittieren, und umfasst:
- einen ersten Teil (40), der sich auf der oberen Fläche der dielektrischen Schicht (2) erstreckt, und
- einen zweiten Teil (41), der sich auf dem zweiten Teil (31) der Abstandsschicht (3), im Inneren der Öffnungen (20), erstreckt, so dass die obere Fläche des zweiten Teils (41) des Stapels (4) auf einer geringeren Höhe als die obere Fläche der dielektrischen Schicht (2) gelegen ist,
wobei der Stapel aus organischen lichtemittierenden Schichten eine Diskontinuität zwischen dem ersten Teil des Stapels und dem zweiten Teil des Stapels aufweist;
g) Bilden einer zweiten Elektrode (E2) auf dem Stapel (4) aus organischen lichtemittierenden Schichten, so dass ein optischer Resonator mit der ersten Elektrode (E1) erhalten wird;
wobei der Schritt d) so durchgeführt wird, dass der zweite Teil (31) der Abstandsschicht (3) erste, zweite und dritte Dicken in den Öffnungen (20) aufweist, die so angepasst sind, dass der optische Resonator die Transmission von rotem, grünem beziehungsweise blauem Licht zulässt, das aus dem von dem Stapel (4) aus organischen lichtemittierenden Schichten emittierten weißen Licht hervorgeht.

2. Verfahren nach Anspruch 1, wobei der Schritt e) so durchgeführt wird, dass der zweite Teil (31) der Abstandsschicht (3) und die dielektrische Schicht (2) nach dem Schritt e) eine Stufenhöhe größer oder gleich 100 nm aufweisen.

3. Verfahren nach Anspruch 1 oder 2, wobei der Schritt e) durch chemischmechanisches Polieren durchgeführt wird.

4. Verfahren nach einem der Ansprüche 1 bis 3, wobei die bei dem Schritt d) gebildete Abstandsschicht (3) mindestens ein elektrisch leitfähiges und im sichtbaren Bereich transparentes Oxid umfasst.

5. Verfahren nach Anspruch 4, wobei das oder die Oxide aus Indiumzinnoxid, Zinnoxid SnO₂, Zinkoxid ZnO ausgewählt sind.

6. Verfahren nach einem der Ansprüche 1 bis 5, wobei der Schritt d) so durchgeführt wird, dass die erste Dicke 100 nm beträgt, die zweite Dicke 50 nm beträgt und die dritte Dicke 10 nm beträgt.

7. Verfahren nach einem der Ansprüche 1 bis 6, wobei die bei dem Schritt c) gebildeten Öffnungen (20) eine Breite zwischen 500 nm und 10 µm aufweisen.

8. Verfahren nach einem der Ansprüche 1 bis 7, wobei die bei dem Schritt b) gebildete dielektrische Schicht (2) aus einem Material ausgeführt ist, das aus SiO₂ und SiN gewählt ist.

9. Verfahren nach einem der Ansprüche 1 bis 8, wobei die bei dem Schritt b) gebildete dielektrische Schicht (2) eine Dicke zwischen 150 nm und 300 nm aufweist.

10. Verfahren nach einem der Ansprüche 1 bis 9, wobei die erste und die zweite Elektrode (E1, E2) aus einem metallischen Material ausgeführt sind, das vorzugsweise aus Al, Ag, Pt, Cr, Ni, W ausgewählt ist, und/oder aus einem transparenten leitfähigen Oxid ausgeführt sind.

11. Verfahren nach einem der Ansprüche 1 bis 10, wobei:
- das bei dem Schritt a) bereitgestellte Substrat (1) im sichtbaren Bereich transparent ist;
- die bei dem Schritt a) bereitgestellte strukturierte erste Elektrode (E1) im sichtbaren Bereich halbtransparent ist;
- die bei dem Schritt g) gebildete zweite Elektrode (E2) im sichtbaren Bereich reflektierend ist.

12. Verfahren nach einem der Ansprüche 1 bis 10, wobei:
- das bei dem Schritt a) bereitgestellte Substrat (1) aus einem Halbleitermaterial, vorzugsweise Silizium, ausgeführt ist oder aus Glas ausgeführt ist;
- die bei dem Schritt a) bereitgestellte strukturierte erste Elektrode (E1) im sichtbaren Bereich reflektierend ist;
- die bei dem Schritt g) gebildete zweite Elektrode (E2) im sichtbaren Bereich halbtransparent ist.

## Claims

1. Method for manufacturing a pixel of an organic light-emitting diode microscreen, comprising the successive steps of:
a) providing a substrate (1) comprising a structured first electrode (E1);
b) forming a dielectric layer (2) on the structured first electrode (E1);
c) forming openings (20) in the dielectric layer (2), such that the structured first electrode (E1) has free areas (ZL), the openings (20) being intended to receive red, green and blue sub-pixels (PR, PV, PB), the dielectric layer (2) having a bottom surface, a top surface and flanks connecting the bottom surface to the top surface;
d) forming a spacer layer (3) that is transparent in the visible spectrum and is electrically conductive, and comprises:
- a first part (30) extending over the top surface of the dielectric layer (2), and
- a second part (31) extending over the free areas (ZL) of the structured first electrode (E1), inside the openings (20), such that the top surface of the second part (31) of the spacer layer (3) is located at a level lower than that of the top surface of the dielectric layer (2);
e) removing the first part (30) of the spacer layer (3);
f) forming a stack (4) of organic light-emitting layers that is configured so as to emit a white light and comprises:
- a first part (40) extending over the top surface of the dielectric layer (2), and
- a second part (41) extending over the second part (31) of the spacer layer (3), inside the openings (20), such that the top surface of the second part (41) of the stack (4) is located at a level lower than that of the top surface of the dielectric layer (2),
the stack of organic light-emitting layers having a discontinuity between the first part of the stack and the second part of the stack;
g) forming a second electrode (E2) on the stack (4) of organic light-emitting layers so as to obtain an optical resonator with the first electrode (E1);
step d) being carried out such that the second part (31) of the spacer layer (3) has first, second and third thicknesses in the openings (20) that are designed such that the optical resonator allows, respectively, the transmission of red, green and blue light from the white light emitted by the stack (4) of organic light-emitting layers.

2. Method according to Claim 1, wherein step e) is carried out such that the second part (31) of the spacer layer (3) and the dielectric layer (2) have a step height greater than or equal to 100 nm at the end of step e).

3. Method according to Claim 1 or 2, wherein step e) is carried out through chemical-mechanical polishing.

4. Method according to one of Claims 1 to 3, wherein the spacer layer (3) formed in step d) comprises at least one oxide that is electrically conductive and transparent in the visible spectrum.

5. Method according to Claim 4, wherein the oxide or oxides are selected from among indium tin oxide, tin oxide SnO₂ and zinc oxide ZnO.

6. Method according to one of Claims 1 to 5, wherein step d) is carried out such that the first thickness is 100 nm, the second thickness is 50 nm, and the third thickness is 10 nm.

7. Method according to one of Claims 1 to 6, wherein the openings (20) formed in step c) have a width of between 500 nm and 10 µm.

8. Method according to one of Claims 1 to 7, wherein the dielectric layer (2) formed in step b) is made of a material chosen from among SiO₂ and SiN.

9. Method according to one of Claims 1 to 8, wherein the dielectric layer (2) formed in step b) has a thickness of between 150 nm and 300 nm.

10. Method according to one of Claims 1 to 9, wherein the first and second electrodes (E1, E2) are made of a metal material, preferably selected from among Al, Ag, Pt, Cr, Ni, W, and/or made of a transparent conductive oxide.

11. Method according to one of Claims 1 to 10, wherein:
- the substrate (1) provided in step a) is transparent in the visible spectrum,
- the structured first electrode (E1) provided in step a) is semi-transparent in the visible spectrum,
- the second electrode (E2) formed in step g) is reflective in the visible spectrum.

12. Method according to one of Claims 1 to 10, wherein:
- the substrate (1) provided in step a) is made of a semiconductor material, preferably silicon, or made of glass,
- the structured first electrode (E1) provided in step a) is reflective in the visible spectrum,
- the second electrode (E2) formed in step g) is semi-transparent in the visible spectrum.
